# EUROPÄISCHE PATENTSCHRIFT

(11) **EP 3 488 207 B1**
(45) Veröffentlichungstag und Bekanntmachung des Hinweises auf die Patenterteilung: **21.07.2021**
(21) Anmeldenummer: 17752027.7
(22) Anmeldetag: 25.07.2017
(51) Int. Cl.: G01L 1/12, G01L 3/10, H01L 41/12

(54) **SENSORKOPF FÜR EINEN KRAFT- ODER DREHMOMENTSENSOR**
SENSOR HEAD FOR A FORCE OR TORQUE SENSOR
TÊTE DE CAPTEUR POUR UN CAPTEUR DE FORCE OU DE COUPLE

(30) Priorität: 25.07.2016 DE 102016113689; 17.11.2016 DE 102016122172
(43) Veröffentlichungstag der Anmeldung: 29.05.2019
(73) Patentinhaber: Trafag AG, 8608 Bubikon (CH)
(72) Erfinder: SCHANZ, Christoph, 72636 Frickenhausen (DE); ZEISEL, Dieter, 8127 Forch (CH)
(74) Vertreter: Kastel, Stefan
(86) Internationale Anmeldenummer: PCT/EP2017/068814
(87) Internationale Veröffentlichungsnummer: WO 2018/019859

(56) Entgegenhaltungen:
- DE-A1- 4 309 413
- DE-A1- 19 929 864
- DE-A1-102014 215 723

## Beschreibung

Die Erfindung betrifft einen Sensorkopf für einen magnetoelastischen Kraft- oder Drehmomentsensor zum Messen einer Kraft oder eines Drehmoments in einem ferromagnetischen Körper.

Magnetoelastische Kraftsensoren oder Drehmomentsensoren sind beispielsweise aus der US 2 912 642, der DE 30 31 997 A1 oder der US 4 503 714 oder aus der EP 0 136 086 A2 bekannt. Weitere magnetoelastische Kraft- oder Drehmomentsensoren sind in der EP 2 397 829 B1 oder der EP 2 615 422 B1 beschrieben.

Bei derartigen Sensoren erfolgt die Kraftmessung oder Drehmomentmessung mittels des magnetoelastischen Effekts. Magnetische Materialien zeigen eine enge Wechselwirkung zwischen ihren magnetischen und mechanischen Eigenschaften. So werden Magnetfeldlinien eines Magnetfeldes, welches in einem ferromagnetischen Körper induziert wird, durch Belastungen des Körpers verändert.

Magnetoelastische Sensoren weisen somit in der Regel eine Magnetfelderzeugungseinrichtung zum Erzeugen eines Magnetfelds in dem ferromagnetischen Körper und eine Messeinrichtung zum Messen einer Magnetfeldänderung unter Belastung auf.

Dabei gibt es im Wesentlichen zwei Grundprinzipien zum Aufbau des jeweiligen Sensorkopfes.

Bei einem ersten Aufbau, wie er beispielsweise in der US 2 912 642 gezeigt ist, wird das Magnetfeld an einem Magnetfeldjoch erzeugt, welches Magnetfelderzeugungsspulen aufweist, wobei ein Messjoch mit Messspulen in einer sich zu dem Magnetfelderzeugungsjoch kreuzenden Richtung angeordnet ist. Bei dem zweiten möglichen Aufbau, wie er in der DE 30 31 997 oder der EP 0 136 086, dort Fig. 9A, gezeigt ist, ist eine Erregerspule zentral um einen Erregerspulenkern herum angeordnet, der sich mittig zwischen Magnetpolen der Magnetfeldmesseinheit befindet. Die Kerne können dabei durch ein weichmagnetisches Material verbunden sein.

Insbesondere weist die Magnetfelderzeugungseinheit einen Flusskonzentrator mit einem weichmagnetischen Erregerkern auf, der durch eine Erregerspule hindurchgeführt ist.

Magnetoelastische Sensoren zeigen im Labor sehr gute Messergebnisse. Obgleich dieses Messprinzip bereits seit Jahrzehnten bekannt ist, hat es jedoch in der Praxis kaum Anwendung gefunden.

Aus der DE 10 2014 215 723 A1 ist eine Sensoranordnung mit einem Kraftaufnehmer und einem Sensorelement bekannt. Das Sensorelement hat gemäß einer Ausgestaltung mehrere in ein Kunststoffmaterial eingebettete U-förmige Flussverstärkungselemente, um die Spulen gewickelt sind, die als kombinierte Erreger- und Messspulen dienen.

Aus der DE 199 29 864 A1 ist ein mit mikromechanischen Fertigungsmethoden gefertigter Sensorkopf für einen Drehmomentsensor bekannt, bei dem zwei in einer Ebene nebeneinander angeordnete Planarspulen als Erregerspulen dienen und zur Magnetfeldmessung magnetfeldempfindliche Halbleiterbauelemente integriert sind.

Aus der DE 43 09 413 A1 ist ein magnetoelastischer Dehnmessstreifen bekannt, bei dem eine Kraft an einem integrierten Dehnstreifen aus magnetoelastischem Material mit Hilfe zweier auf einem folienartigen Trägermaterial aufgedruckter Spiralspulen erfasst wird.

Unter anderem aus den Druckschriften DE 199 28 842 A1, DE 20 2014 001 072 U1, DE 10 2012 200 195 A1, DE 10 2011 112 826 A1, DE 10 2007 062 537 A1, und DE 10 2006 025 098 A1 sind ferritische Folien bekannt.

Die Erfindung hat sich zur Aufgabe gestellt, Kraftmesssensoren nach dem magnetoelastischen Prinzip und Drehmomentmesssensoren aufzubauen, die kostengünstig herstellbar sind und für unterschiedliche praktische Anwendungen geeignet sind.

Hierzu wird ein Sensorkopf nach Anspruch 1 sowie ein Verfahren zum Herstellen eines Sensorkopfes nach dem Anspruch 9 vorgeschlagen.

Vorteilhafte Ausgestaltungen sind Gegenstand der Unteransprüche.

Die Erfindung schafft gemäß einem ersten Aspekt einen Sensorkopf für einen magnetoelastischen Kraft- oder Drehmomentsensor zum Messen einer Kraft oder eines Drehmoments in einem ferromagnetischen Körper, umfassend:
eine Magnetfelderzeugungseinheit zum Erzeugen eines Magnetfelds in dem ferromagnetischen Körper und eine Magnetfeldmesseinheit zum Messen einer Magnetfeldänderung in dem ferromagnetischen Körper,
wobei die Magnetfelderzeugungseinheit eine Erregerspule und ein weichmagnetisches Erreger-Flussverstärkungselement aufweist,
wobei die Magnetfeldmesseinheit mehrere Messspulen mit einem weichmagnetischen Mess-Flussverstärkungselement aufweist,
wobei wenigstens die Erregerspule und die Messspulen in einem gemeinsamen integrierten Bauteil integriert sind.

Eine Ausführungsform der Erfindung schafft einen Sensorkopf für einen magnetoelastischen Kraft- oder Drehmomentsensor zum Messen einer Kraft oder eines Drehmoments in einem ferromagnetischen Körper, umfassend:
eine Magnetfelderzeugungseinheit zum Erzeugen eines Magnetfelds in dem ferromagnetischen Körper und eine Magnetfeldmesseinheit zum Messen einer Magnetfeldänderung in dem ferromagnetischen Körper,
wobei die Magnetfelderzeugungseinheit eine Erregerspule um einen weichmagnetischen Erregerkern aufweist,
wobei die Magnetfeldmesseinheit mehrere Messspulen mit einem weichmagnetischen Messkern aufweist,
wobei wenigstens die Erregerspule und die Messspulen an einem gemeinsamen integrierten Baustein integriert sind.

Gemäß einer Alternative der Erfindung ist der integrierte Baustein ein Leiterplattenelement. Gemäß einer weiteren Alternative der Erfindung ist der integrierte Baustein ein MEMS-Baustein.

Vorteilhaft ist vorgesehen, dass die Spulen in Leiterplattentechnik an einem Leiterplattenelement ausgebildet sind. Es sind aber auch andere Möglichkeiten zum gemeinsamen integralen Aufbau der Spulen in einem Baustein denkbar, wie MEMS-Techniken, Halbleiterfertigungstechniken oder additive Fertigungsverfahren.

Bei dem erfindungsgemäßen Sensorkopf sind die Spulen aus Planarspulen aufgebaut, die in einer Leiterschicht des integrierten Bausteins ausgebildet sind. Mehrere mit Planarspulen versehene Leiterschichten sind mit entsprechend isolierenden Zwischenlagen zu einem Spulenpaket zusammengefasst.

Bei dem erfindungsgemäßen Sensorkopf ist hierzu in einer Leiterschicht eine Planarspule zum Bilden zumindest eines Teils einer ersten Messspule und eine Planarspule zum Bilden einer zweiten Messspule und/oder einer Erregerspule in einer Ebene angeordnet. Durch Anordnung mehrerer solcher Leiterschichten mit mehreren Planarspulen werden gleichzeitig Spulenpakete zum Bilden einer ersten Messspule und einer zweiten Messspule und einer Erregerspule gleichzeitig aufgebaut.

Bisher sind die Spulen aufwändig gewickelt und einer der größten Kostenfaktoren für derartige Sensorköpfe. Mit der Erfindung lassen sich durch integrierte Fertigung der Spulen erheblicher Arbeitsaufwand und erheblichen Kosten einsparen. Außerdem kann so der Sensorkopf oder zumindest dessen Spuleneinheit industriell in Großserie gefertigt werden. Die Spuleneinheit kann sehr kompakt aufgebaut werden. Vorteilhaft können Packaging-Verfahren zum Schutz des Sensorkopfes durchgeführt werden.

Bei einer Alternative mit Aufbau in Leiterplattentechnik wird ein Leiterplattenelement, das eine leitfähige Schicht und eine aus einem Isolator gebildete Trägerschicht aufweist, vorgesehen, dann wird wenigstens eine Planarspule an der leitfähigen Schicht, z.B. durch lithografische Techniken hergestellt. Mehrere solcher Leiterplatten werden zu einem Paket gestapelt, wobei die einzelnen Leiterschichten mit den Planarspulteilen durch Vias kontaktiert werden können. Magnetische Kerne können durch Ausbilden von Kavitäten und Füllen mit ferromagnetischen Material ausgebildet werden.

In einer alternativen Bauweise werden Isolatorschichten und Leiterstrukturen zum Bilden der Spulen schichtweise mit generativen Fertigungstechniken und/oder mit aus der Halbleitertechnik zum Aufbau von integrierten Schaltkreisen bekannten Techniken aufgebaut. Der Aufbau geschieht auch hier so, dass in einer gemeinsamen Ebene Leiterschichten derart strukturiert aufgebracht werden, dass mehrere Planarspulen nebeneinander zum Bilden einer ersten Messspule und einer zweiten Messspule und einer Erregerspule gebildet werden. Mehrere solche mit Planarspulen versehene Schichten mit Isolationsschichten dazwischen werden zu Spulenpaketen aufgebaut. Dies kann in generativer Weise Schicht für Schicht geschehene, oder es werden Einzelplatten mit wenigstens einer Leiterschicht mit Planarspulenbereichen und einer Isolationsschicht aufgebaut und dann miteinander zu einem Paket verbunden. Auch hier kann es Durchgänge durch die Isolationsschichten zur elektrischen Verbindung mittels leitfähiger Vias geben. Magnetische Kerne können auch durch entsprechenden Materialauftrag, z.B. in Maskentechnik oder über Pulverauftrag und Lasersintern aufgebracht werden. Alternativ können Kavitäten gefertigt werden und mit weichmagnetischen Materialien befüllt werden.

Es ist bevorzugt, dass die Messkerne einer ersten Messspule und einer zweiten Messspule zum Bilden eines Magnetkreises mittels eines Jochs aus weichmagnetischem Material verbunden sind.

Es ist bevorzugt, dass das Joch zumindest teilweise in den integrierten Baustein eingelassen ist oder darin integriert ist. Insbesondere ist das Joch in dem Leiterplattenelement eingelassen oder in dem MEMS-Baustein integriert.

Es ist bevorzugt, dass der Erregerkern einen Flusskonzentrator bildet, der als zentraler Magnetpol zwischen wenigstens zwei Messspulen angeordnet ist.

Es ist bevorzugt, dass der Erregerkern mit dem Joch in Kontaktverbindung steht.

Es ist bevorzugt, dass wenigstens eine ferritische Folie vorgesehen ist.

Es ist bevorzugt, dass die ferritische Folie eine Dicke von 0,1 mm bis 3 mm, insbesondere 0,1 mm bis 0,5 mm oder 1 mm bis 2 mm hat.

Es ist bevorzugt, dass die ferritische Folie in das integrierte Bauteil, d.h. das Leiterplattenelement oder den MEMS-Baustein, eingebettet ist und/oder auf das Bauteil aufgebracht ist und/oder auf eine Leiterplatte, an der die Spulen ausgebildet sind, angebracht ist, insbesondere aufgeklebt ist.

Es ist bevorzugt, dass die wenigstens eine ferritische Folie zumindest einen Teil eines der weichmagnetischen Flussverstärkungselemente bildet.

Es ist bevorzugt, dass der Erregerkern und/oder die Messkerne und/oder das Joch durch die wenigstens eine ferritische Folie gebildet ist.

Bevorzugt umfasst der Sensorkopf einen ersten integrierten Baustein - in Form ein erstes Leiterplattenelement oder einen ersten MEMS-Baustein -, an dem wenigstens die Erregerspule und mehrere Messspulen derart integriert vorgesehen sind, dass mehrere Magnetpole gebildet werden, und einen zweiten integrierten Baustein - in Form ein zweites Leiterplattenelement oder einen zweiten MEMS-Baustein -, in den wenigstens ein weichmagnetisches Material zum Verbinden und/oder Bilden von weichmagnetischen Flussverstärkungselementen wie insbesondere Kerne der Magnetpole eingelassen oder integriert ist, wobei der erste und der zweite integrierte Baustein miteinander verbunden sind.

Bevorzugt umfasst der Sensorkopf eine integrierte Schaltung mit einer signalverarbeitenden Elektronik, die an dem integrierten Baustein, d.h. dem Leiterplattenelement oder dem MEMS-Baustein, angeordnet oder daran angebonded oder angelötet oder darin integriert ist.

Bei dem erfindungsgemäßen Sensorkopf weisen die in den Baustein integrierten Spulen Windungen auf, die durch eine an einer Leitschicht des Bausteins ausgebildete Spirale gebildet sind.

Bei dem erfindungsgemäßen Sensorkopf weisen wenigstens eine Erregerspule, eine erste Messspule und eine zweite Messspule Windungen auf, die durch eine gemeinsame Leiterschicht des integrierten Bausteins - in Form des Leiterplattenelements oder des MEMS-Bausteins - gebildet sind.

Es ist bevorzugt, dass der integrierte Baustein, wie z.B. das Leiterplattenelement bzw. der MEMS-Baustein, mit den integrierten Spulen und den weichmagnetischen Kernen durch ein Polymer umspritzt ist.

Die hier vorliegende Erfindung ist für unterschiedliche Basisprinzipien zum Aufbau des Drehmomentsensors einschließlich der Bauart mit sich kreuzenden Jochen als auch der Bauart mit zentralem Flusskonzentrator geeignet.

Besonders bevorzugt weist der erfindungsgemäße Sensorkopf den Aufbau wie aus der DE 30 31 997 A1 gezeigt auf. Vorzugsweise sind hierzu ein mittiger Erregerkern und eine Mehrzahl von Messpolpaaren vorgesehen. Besonders bevorzugt sind wenigstens zwei Messpolpaare vorgesehen; der Sensorkopf funktioniert aber auch mit drei Magnetpolen, also beispielsweise einem Erregerpol und zwei Messpolen.

Gemäß einem weiteren Aspekt betrifft die Erfindung ein Verfahren zum Herstellen eines Sensorkopfes für einen magnetoelastischen Kraft- oder Drehmomentsensor zum Messen einer Kraft oder eines Drehmoments in einem ferromagnetischen Körper, welcher Sensorkopf eine Magnetfelderzeugungseinheit zum Erzeugen eines Magnetfelds in dem ferromagnetischen Körper und eine Magnetfeldmesseinheit zum Messen einer Magnetfeldänderung in dem ferromagnetischen Körper umfasst, wobei die Magnetfelderzeugungseinheit eine Erregerspule und ein weichmagnetisches Erreger-Flussverstärkungselement aufweist und die Magnetfeldmesseinheit eine Messspule und ein weichmagnetischen Mess-Flussverstärkungselement aufweist, umfassend die Alternativen:
a) Vorsehen wenigstens einer Leiterplatte, Strukturieren einer Leitschicht der Leiterplatte, um Windungen der Erregerspule und der Messspule auszubilden, oder
b) integriertes Ausbilden von Windungen der Erregerspule und der Messspule durch mikromechanische Fertigung und/oder Strukturierung und/oder additive Fertigungsverfahren.

Eine bevorzugte Ausgestaltung der Erfindung schafft ein Verfahren zum Herstellen eines Sensorkopfes für einen magnetoelastischen Kraft- oder Drehmomentsensor zum Messen einer Kraft oder eines Drehmoments in einem ferromagnetischen Körper, welcher Sensorkopf eine Magnetfelderzeugungseinheit zum Erzeugen eines Magnetfelds in dem ferromagnetischen Körper und eine Magnetfeldmesseinheit zum Messen einer Magnetfeldänderung in dem ferromagnetischen Körper umfasst, wobei die Magnetfelderzeugungseinheit eine Erregerspule um einen weichmagnetischen Erregerkern aufweist und die Magnetfeldmesseinheit eine Messspule um einen weichmagnetischen Messmagnetpolkern aufweist, umfassend die Schritte:
a) Vorsehen wenigstens einer Leiterplatte und Strukturieren einer Leitschicht der Leiterplatte, um Windungen der Erregerspule und der Messspule auszubilden, oder
b) integriertes Ausbilden von Windungen der Erregerspule und der Messspule durch mikromechanische Fertigung und/oder Strukturierung und/oder durch generative Fertigungsverfahren.

Es ist bevorzugt, dass Schritt a) enthält: Aufbringen, insbesondere Aufkleben, wenigstens einer ferritischen Folie auf die Leiterplatte zum Bilden der Flussverstärkungselemente.

Vorzugsweise umfasst das Verfahren den Schritt:
Herstellen der wenigstens einen ferritischen Folie in einem Stanzprozess.

Vorzugsweise umfasst das Verfahren den Schritt:
Bereitstellen der wenigstens einen ferritischen Folie mit einer Dicke von 0,1 mm bis 3 mm, insbesondere 0,2 mm bis 2 mm oder 0,1 bis 0,5 mm und 1 mm bis 2 mm.

Vorzugsweise umfasst das Verfahren den Schritt:
Bereitstellen einer Folie aus oder mit einem Eisenoxyd.

Vorzugsweise umfasst Schritt a): Einbetten eines weichmagnetischen Materials in die Leiterplatte zum Bilden der Kerne bzw. der Flussverstärkungselemente.

Vorzugsweise umfasst Schritt b): integriertes Ausbilden von Windungen der Erregerspule und der Messspule und der weichmagnetischen Flussverstärkungselemente wie z.B. der Kerne durch mikromechanische Fertigung und/oder Strukturierung (MEMS) und/oder durch generative Fertigungsverfahren.

Vorzugsweise umfasst das Verfahren:
Vorsehen einer zweiten Leiterplatte mit einem eingelagerten weichmagnetischen Material zum Bilden eines Magnetkreises mit den Flussverstärkungselementen (z.B. Kernen) und Verbinden der ersten Leiterplatte mit den Windungen und der zweiten Leiterplatte derart, dass wenigstens drei magnetisch miteinander verbundene Magnetpole mit Magnetpolflussverstärkern und zumindest teilweise durch die Leiterschicht der ersten Leiterplatte gebildeten, den Flussverstärkungselementen zugeordneten Spulen gebildet werden.

Vorzugsweise umfasst das Verfahren:
Vorsehen eines Chips mit einer signalverarbeitenden Elektronik und elektrisches Verbinden von Anschlüssen des Chips mit den Spulen, um so ein Sensorpackage zu bilden.

Vorzugsweise umfasst das Verfahren:
Umspritzen zumindest der Leiterplatte oder des durch mikromechanische Fertigung gebildeten integralen MEMS-Bausteins mit den Spulen und den Flussverstärkungselementen durch ein Polymermaterial.

Eine besondere Ausgestaltung der Erfindung betrifft ein Sensorpackage umfassend ein magnetisch-induktiv messendes Sensorelement (vorzugsweise mit Spulen und Ferritkern), das vorzugsweise in einer Leiterplatte (pcb = printed circuit board) integriert ist, und eine ebenfalls integrierte signalverarbeitende Elektronik für den Zweck einer berührungslosen, magnetisch induktiven Kraft- oder Drehmomentmessung in einem ferromagnetischen Körper. Das gesamte Package kann dabei wahlweise mit einem Polymer umspritzt oder als "Huckepack-System" ausgeführt werden.

Die so erhältlichen Chip-Packages sind sehr attraktiv wegen Kosten und potenzieller Massenanwendungen. Mögliche Einsatzgebiete sind z.B. E-Bikes, E-Wheelys, Elektromotoren, Torque Vectoring und Messung anderer Kraft-, Biege-, Zug-, Druckkräfte.

Gemäß einer Ausgestaltung wird der Sensorkopf mit Packaging-Verfahren hergestellt. Vorzugsweise werden Technologien eingesetzt, wie sie für das Packaging von Halbleiterbauelementen bekannt sind. Es wird hier explizit für weitere Einzelheiten auf Wikipedia, "Electronic packaging", abgerufen am 25.07.2016 und Wikipedia, "Semiconductor packaging" und "Integrated circuit packaging", abgerufen am 25.07.2016 verwiesen.

Besonders bevorzugt wird die Magnetfelderzeugungseinheit sowie die Magnetfeldmesseinheit in einem integrierten Baustein mittels mikromechanischer Fertigungsverfahren oder mittels Leiterplattentechnik implementiert.

Insbesondere können die Spulen als Scheibentyp-Spulen an Leiterschichten entweder additiv oder durch Wegnahme von Material hergestellt werden. Insbesondere werden einzelne Windungen spiralförmig hergestellt; eine größere Anzahl von Windungen kann durch ein Hintereinanderschalten mehrerer auf unterschiedlichen Ebenen ausgebildeten Spiralstrukturen erzeugt werden.

So können mehrere Leiterplatten mit Spiralstrukturen aufeinandergestapelt werden und durch Durchgangskontaktierungen miteinander verschaltet werden. Auch kann weichmagnetisches Material zum Bilden von Kernen und Jochen zwecks Erzeugen von Magnetkreisen, wie sie vom Grundaufbau her in der US 2 912 642, der DE 30 31 997 A1, der US 4 503 714, der US 4 646 576 oder der US 4 697 459 gezeigt sind, durch mikromechanische und/oder additive Fertigungsverfahren hergestellt werden.

In besonders bevorzugter Weise enthält ein entsprechend durch mikromechanische und/oder additive Fertigungsverfahren hergestellter Sensorkopf ein Sensor-Packaging einschließlich eines integrierten Schaltkreises mit einer elektronischen Signalverarbeitungseinheit. Diese kann beispielsweise als ASIC ausgebildet sein.

Ausführungsbeispiele der Erfindung werden im Folgenden anhand der beigefügten Zeichnungen näher erläutert. Darin zeigt:
- Fig. 1: eine Schnittdarstellung durch einen Sensorkopf gemäß einer ersten Ausführungsform;
- Fig. 2: eine Schnittdarstellung durch einen Sensorkopf gemäß einer zweiten Ausführungsform;
- Fig. 3: eine Schnittdarstellung durch einen Sensorkopf gemäß einer dritten Ausführungsform;
- Fig. 4: einen Schnitt entlang der Linie IV-IV von Fig. 3 und
- Fig. 5: einen Schnitt durch eine weitere Ausführungsform eines Bauteils zum Bilden des Sensorkopfes; und
- Fig. 6: einen Ansicht wie in Fig. 5, die den entsprechenden Baustein der Fig. 5 bei der Ausgestaltung gemäß den Ausführungsformen der Fig. 1 bis 4 zeigt.

Die Figuren zeigen unterschiedliche Ausführungsformen eines Sensorkopfs 10 für einen magnetoelastischen Kraft- oder Drehmomentsensor zum Messen einer Kraft oder eines Drehmoments in einem ferromagnetischen Körper 9.

Der Sensorkopf 10 ist durch ein Sensorpackage 12 gebildet, das durch Packagingverfahren aufgebaut ist. Weiter erfolgt die Fertigung mit mikromechanischen Fertigungsmethoden (MEMS), additiver Fertigung oder in Leiterplattentechnik. Auch Kombinationen sind möglich.

Der Sensorkopf 10 umfasst eine Magnetfelderzeugungseinheit 14 zum Erzeugen eines Magnetfelds in dem ferromagnetischen Körper 9 und eine Magnetfeldmesseinheit 16 zum Messen einer Magnetfeldänderung in dem ferromagnetischen Körper 9.

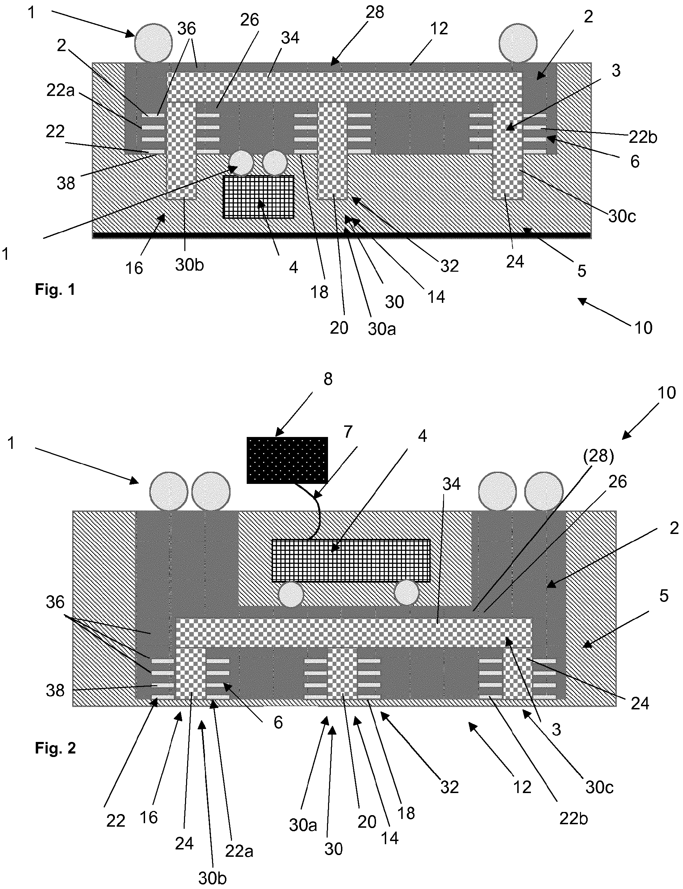

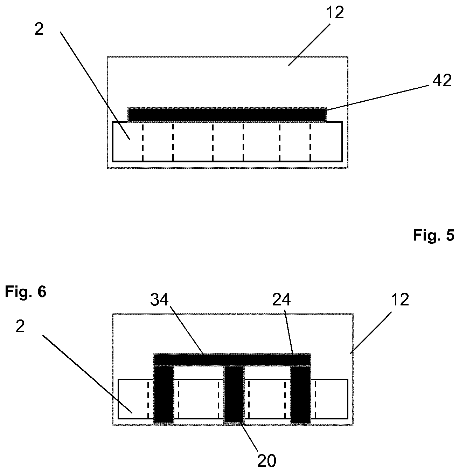

Die Magnetfelderzeugungseinheit 14 weist eine Erregerspule 18 und ein Flussverstärkungselement auf. Bei den Ausgestaltungen der Fig. 1 bis 4 ist die Erregerspule 18 um einen weichmagnetischen Erregerkern 20 herum vorgesehen, bei der Ausgestaltung von Fig. 5 ist zum Bilden des Flussverstärkungselements anstelle des Erregerkerns 20 oder bei anderen, nicht dargestellten Ausführungen zusätzlich zu dem Erregerkern 20 wenigstens eine ferritische Folie 42 vorgesehen.

Die Magnetfeldmesseinheit 16 weist mehrere Messspulen 22 auf, die jeweils ein weichmagnetischen Flussverstärkungselement wie insbesondere einen Messkern 24 oder einen Bereich wenigstens einer ferritischen Folie 42, umfassen.

Die Erregerspule 18 und die Messspulen 22 sind an einem gemeinsamen Leiterplattenelement 26 und/oder integrierten Baustein, insbesondere MEMS-Baustein 28, integriert aufgebaut.

In den Figuren sind Ausführungsbeispiele des Sensorkopfes 10 mit insgesamt fünf Magnetpolen 30 dargestellt, wobei ein zentraler erster Magnetpol 30a Teil der Magnetfelderzeugungseinheit 14 ist und die Erregerspule 18 und das Erreger-Flussverstärkungselement wie den Erregerkern 20 oder einen Bereich der wenigstens einen ferritischen Folie 42 aufweist. Der erste Magnetpol 30a wirkt als Flusskonzentrator 32 zum Konzentrieren des durch die Erregerspule 18 erzeugten magnetischen Flusses in der Oberfläche des zu messenden Messgegenstandes 9.

Die weiteren Magnetpole 30b bis 30e sind die Pole der Magnetfeldmesseinheit 16. In den hier dargestellten Ausführungsformen weist die Magnetfeldmesseinheit 16 jeweils zwei Magnetpolpaare 30b-30c, 30d-30e zum Messen der Magnetfelder in unterschiedlichen Ausrichtungen auf. Eine andere, hier nicht näher dargestellte Ausführungsform kommt mit nur zwei Magnetpolen der Magnetfeldmesseinheit 16 aus; hier sind der vierte Magnetpol 30d und der fünfte Magnetpol 30e weggelassen.

Bei den in den Fig. 1 bis 4 dargestellten Ausführungsformen sind alle Magnetpole 30 mit Kernen versehen, wobei die Kerne des zweiten bis fünften Magnetpols die Messkerne 24 bilden und durch die jeweiligen Messspulen 22a bis 22d umgeben sind. Der Kern des ersten Magnetpols 30a ist der Erregerkern 20, der durch die Messspule 22 umgeben ist. Alle Kerne 24, 20 sind durch weichmagnetisches Material gebildet. Zumindest die Kerne der Magnetpolpaare 30a-30b oder 30c-30d der Magnetfeldmesseinheit 16 sind miteinander zu einem Joch aus weichmagnetischem Material verbunden. Das weichmagnetische Material ist insbesondere durch einen Ferritkern 3 gebildet.

In den in den Fig. 1 bis 4 dargestellten Ausführungsformen sind alle Magnetpole 30a-30e durch den Ferritkern 3 verbunden; dieser kann eine topfförmige oder sternförmige Gestalt haben, wobei die Messkerne 24 bzw. der Erregerkern 20 durch entsprechend zu einer Richtung vorstehende Vorsprünge gebildet sind, um die die jeweiligen Spulen 22, 22a-22d vorgesehen sind.

Die Spulen 22, 22a-22d sind als in dem integrierten Baustein, also insbesondere in dem Leiterplattenelement 26 oder in dem MEMS-Baustein 28, integrierte Spulen 6 ausgebildet.

Insbesondere weist das Leiterplattenelement 26 wenigstens eine gedruckte Leiterplatte (Printed Circuit Board, kurz PCB) auf, die einen Träger aus Isoliermaterial und wenigstens einer Leiterschicht 38 aufweist.

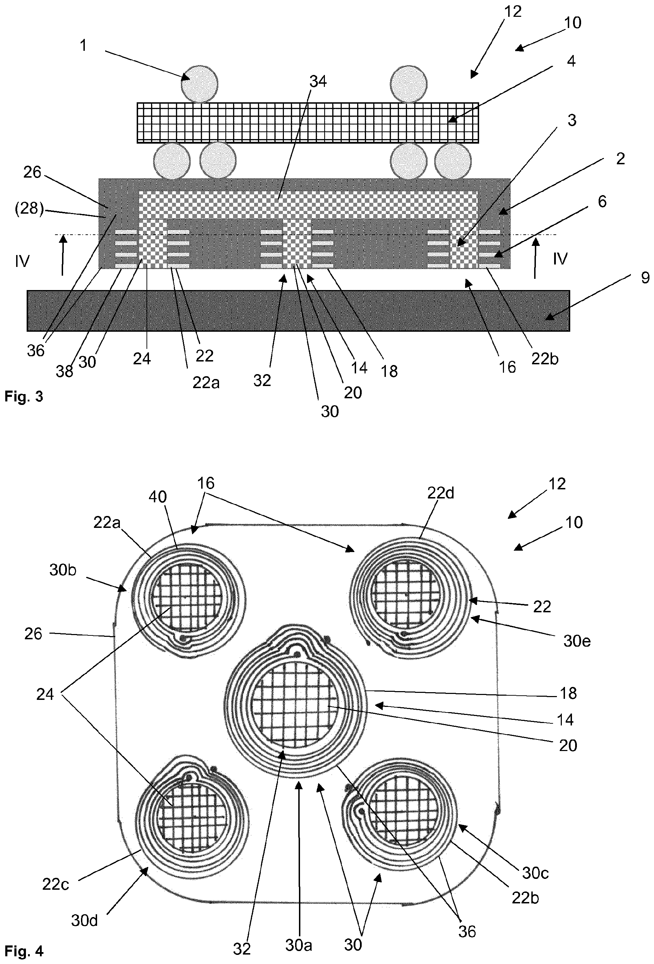

Wie aus Fig. 4 ersichtlich, ist die Leiterschicht 38 derart strukturiert, dass Windungen 40 der integrierten Spulen 6 ausgebildet sind. Die Windungen 40 sind insbesondere spiralförmig ausgebildet, wobei an den Enden Kontaktpads ausgebildet sind, wobei einer der Kontaktpads durch eine Durchgangskontaktierung durch die Isolationsschicht geführt ist. Durch Aufeinanderlegen und Hintereinanderschalten mehrerer derartiger Leiterplatten 36 mit den entsprechend spiralförmig gebildeten Windungen 40 können die integrierten Spulen 6 mit einer Vielzahl von Windungen 40 ausgebildet werden.

Die Innenräume zentral zwischen den Windungen 40 können z.B. ausgebohrt werden und mit ferromagnetischem Material zum Bilden des Ferritkerns 3 aufgefüllt werden.

Der Ferritkern kann auch durch additive Fertigungsverfahren oder durch andere Packaging-Verfahren oder mikromechanische Fertigungsverfahren in das Sensorpackage 12 eingebracht werden. Insgesamt kann der Sensorkopf 10 mit den integrierten Spulen 6 und dem ferromagnetischen Material zum Bilden des Jochs 34 und der Kerne 20, 24 in mikromechanischer Fertigung aufgebaut werden.

Bei allen Ausführungsformen weist das Sensorpackage 12 darüber hinaus eine signalverarbeitende Elektronik 4, insbesondere in Form einer integrierten Schaltung, vorzugsweise in Form eines IC-Bausteins, mehr insbesondere in Form eines ASICs, auf, die in den Sensorkopf 10 integriert ist. Auch hierzu werden vorzugsweise Packaging-Verfahren und/oder mikromechanische Fertigungsverfahren verwendet. Vorzugsweise ist die signalverarbeitende Elektronik 4 mittels eines Arrays von Lötkugeln 1 an die jeweiligen Kontakte der integrierten Spulen 6 angeschlossen.

Das Leiterplattenelement 26 bzw. der MEMS-Baustein 28 mit der signalverarbeitenden Elektronik 4 kann mittels eines polymeren Materials umspritzt sein, wie dies bei den Ausführungsformen der Fig. 1 und 2 als Umspritzung 5 dargestellt ist. Fig. 3 zeigt eine "Huckepack-Anordnung" des Leiterplattenelements 26 bzw. des MEMS-Bausteins 28 mit den integrierten Spulen 6 und dem integrierten Ferritkern 3 auf der signalverarbeitenden Elektronik 4.

Die signalverarbeitende Elektronik 4 kann mittels Draht oder Kabel 7 oder einer sonstigen leitenden Verbindung mit einer Auswerteeinheit 8 verbunden sein. Diese Auswerteeinheit (ECU - Electrical Control Unit) kann einen Speicher und einen Prozessor enthalten.

Um das Magnetfeld in magnetisch Induktiven Sensoren zu lenken, ist ein ferritisches Material vorgesehen. Bei den Fig. 1 bis 4 kann dafür der Einsatz von üblichen Materialien wie z.B. gesinterten Ferriten zum Bilden von Flussverstärkungselementen wie insbesondere Kernen und Joche vorgesehen sein. Derartige gesinterte Ferrite haben den Nachteil, dass die Ferrite spröde sind und starr, d.h. sie können nicht in jeder Form hergestellt werden und können durch mechanische Schocks zerstört werden. Bei der Ausgestaltung von Fig. 5 ist daher wenigstens eine ferritische Folie 42 als ferritisches Material vorgesehen.

Hier ist insbesondere eine ferritische Folie 42 zum Bilden von Flussverstärkungselementen anstelle der Kerne 20, 24 und/oder zum Bilden des Joches oder anstelle des Joches 34 vorgesehen.

Eine Ferritische Folie 42 kann durch einen Stanzprozess in der beliebigen Größe und Dimension hergestellt werden und aufgeklebt werden. Durch den Einsatz der ferritischen Folie 42 können deutlich flexiblere Dimensionen in der Ausgestaltung des Sensors erreicht werden.

Die ferritische Folie hat einen Durchmesser von wenigen 1/10mm (bis hin zu 1-2 mm bei höheren Leistungen) und wird auch für Abschirmzwecke verwendet, d.h. die Störempfindlichkeit der geringen Signale (typischerweise im zweistelligen mV Bereich) wird deutlich herabgesetzt. Materialien sind typischerweise Eisenoxyde (wie Magnetband, Material für Tonbandkassetten oder dergleichen).

Ansonsten kann der in Fig. 5 gezeigte Baustein alle anhand der Ausführungen der Fig. 1 bis 4 erläuterten Merkmale und Elemente aufweisen und in dem Sensorkopf 10 eingesetzt werden. Fig. 6 zeigt als Vergleich zu Fig. 5 die gleiche Ansicht für den entsprechenden Baustein mit gesintertem Ferrit, wie er in den zuvorigen Ausführungen verwendet sein kann. Wie ersichtlich kann der Baustein von Fig. 5 die entsprechenden Bausteine der Fig. 1 bis 4 ersetzen.

Ein Vergleich der Fig. 5 und 6 zeigt auch, dass die ferritische Folie 42 räumlich sich über die Orte der Kerne der Spulen hinaus erstrecken kann.

### Bezugszeichenliste:

- 1: BGA Ball Grid Array, Lötkugeln
- 2: PCB mit integrierter Spule
- 3: In PCB eingelassener Ferritkern
- 4: Signalverarbeitende Elektronik (ASIC)
- 5: Moldcompound (Umspritzung)
- 6: Integrierte Spulen
- 7: Draht oder Kabel (Leitende Verbindung)
- 8: Auswerteeinheit ECU (electrical control unit), Speicher, Prozessor
- 9: Messgegenstand (Welle, Zylinder, ferromagnetischer Körper)
- 10: Sensorkopf
- 12: Sensorpackage
- 14: Magnetfelderzeugungseinheit
- 16: Magnetfeldmesseinheit
- 18: Erregerspule
- 20: Erregerkern
- 22: Messspule
- 22a: erste Messspule
- 22b: zweite Messspule
- 22c: dritte Messspule
- 22d: vierte Messspule
- 24: Messkern
- 26: Leiterplattenelement
- 28: MEMS-Baustein
- 30: Magnetpol
- 30a: erster Magnetpol
- 30b: zweiter Magnetpol
- 30c: dritter Magnetpol
- 30d: vierter Magnetpol
- 30e: fünfter Magnetpol
- 32: Flusskonzentrator
- 34: Joch
- 36: Leiterplatte
- 38: Leiterschicht
- 40: Windungen
- 42: ferritische Folie

## Patentansprüche

1. Sensorkopf (10) für einen magnetoelastischen Kraft- oder Drehmomentsensor zum Messen einer Kraft oder eines Drehmoments in einem ferromagnetischen Körper (9), umfassend:
eine Magnetfelderzeugungseinheit (14) zum Erzeugen eines Magnetfelds in dem ferromagnetischen Körper (9) und eine Magnetfeldmesseinheit (16) zum Messen einer Magnetfeldänderung in dem ferromagnetischen Körper (9),
wobei die Magnetfelderzeugungseinheit (14) eine Erregerspule (18) und ein weichmagnetisches Erreger-Flussverstärkungselement (20) aufweist,
wobei die Magnetfeldmesseinheit (16) mehrere Messspulen (22) mit einem weichmagnetischen Mess-Flussverstärkungselement (24) aufweist,
wobei wenigstens die Erregerspule (18) und die Messspulen (22, 22a-22d) an einem gemeinsamen Leiterplattenelement (26) oder MEMS-Baustein (28) integriert sind,
wobei die Erregerspule (18) und die Messspulen (22, 22a-22d) aus Planarspulen aufgebaut sind, die in einer Leiterschicht (38) des Leiterplattenelements (26) oder des MEMS-Bausteins (28) ausgebildet sind,
wobei in der Leiterschicht (38) eine Planarspule zum Bilden eines Teils einer ersten Messspule (22a) und eine Planarspule zum Bilden eines Teils einer zweiten Messspule (22b) und eine Planarspule zum Bilden eines Teils einer Erregerspule (18) in einer Ebene angeordnet sind und mehrere solcher Leiterschichten mit mehreren Planarspulen mit isolierenden Zwischenlagen angeordnet sind, um Spulenpakete zu bilden, die die erste Messspule (22, 22a) und die zweite Messspule (22, 22b) und die Erregerspule (18) bilden.

2. Sensorkopf nach Anspruch 1,
**dadurch gekennzeichnet,**
**dass** das Leiterplattenelement (26) mehrere Leiterplatten (36) aufweist, die jeweils eine leitfähige Schicht (38) und eine aus einem Isolator gebildete Trägerschicht aufweisen und die zu einem Paket gestapelt sind.

3. Sensorkopf nach einem der voranstehenden Ansprüche,
**dadurch gekennzeichnet,**
**dass** das weichmagnetische Erreger-Flussverstärkungselement ein weichmagnetischer Erregerkern (20) ist, um den herum die Erregerspule (18) angeordnet ist und
**dass** die Messspulen (22) mit einem weichmagnetischen Messkern (24) als Mess-Flussverstärkungselement versehen sind.

4. Sensorkopf (10) nach einem der voranstehenden Ansprüche,
**dadurch gekennzeichnet,**
**dass** wenigstens eine ferritische Folie (42) vorgesehen ist, die zumindest einen Teil eines der weichmagnetischen Flussverstärkungselemente bildet.

5. Sensorkopf (10) nach Anspruch 2 und nach Anspruch 4,
**dadurch gekennzeichnet,**
**dass** die ferritische Folie (42) auf das Leiterplattenelement (26) aufgeklebt ist.

6. Sensorkopf (10) nach einem der voranstehenden Ansprüche, **gekennzeichnet durch** ein erstes Leiterplattenelement (26), an dem wenigstens die Erregerspule (18) und mehrere Messspulen (22, 22a-22d) derart integriert vorgesehen sind, dass mehrere Magnetpole (30, 30a-30e) gebildet werden, und **durch** ein zweites Leiterplattenelement (26), in den wenigstens ein weichmagnetisches Material zum Verbinden und/oder Bilden von weichmagnetischen Kernen der Magnetpole (30, 30a-30e) eingelassen oder integriert ist, wobei das erste und das zweite Leiterplattenelement (26) miteinander verbunden sind; oder
**gekennzeichnet durch** einen ersten MEMS-Baustein (28), an dem wenigstens die Erregerspule (18) und mehrere Messspulen (22, 22a-22d) derart integriert vorgesehen sind, dass mehrere Magnetpole (30, 30a-30e) gebildet werden, und **durch** einen zweiten MEMS-Baustein (28), in den wenigstens ein weichmagnetisches Material zum Verbinden und/oder Bilden von weichmagnetischen Kernen der Magnetpole (30, 30a-30e) eingelassen oder integriert ist, wobei der erste und der zweite MEMS-Baustein (26) miteinander verbunden sind.

7. Sensorkopf (10) nach einem der voranstehenden Ansprüche, **gekennzeichnet durch** eine integrierte Schaltung, die an dem Leiterplattenelement (26) oder dem MEMS-Baustein (28) angeordnet oder daran angebonded oder angelötet oder als integrierter Teil davon ausgebildet ist.

8. Sensorkopf (10) nach einem der voranstehenden Ansprüche,
**dadurch gekennzeichnet,**
**dass** das Leiterplattenelement (26) oder der MEMS-Baustein (28) mit den integrierten Spulen (6) und den weichmagnetischen Flussverstärkungselementen (20, 24, 34, 42) durch ein Polymer umspritzt ist.

9. Verfahren zum Herstellen eines Sensorkopfes (10) für einen magnetoelastischen Kraft- oder Drehmomentsensor zum Messen einer Kraft oder eines Drehmoments in einem ferromagnetischen Körper (9), welcher Sensorkopf (10) eine Magnetfelderzeugungseinheit (14) zum Erzeugen eines Magnetfelds in dem ferromagnetischen Körper (9) und eine Magnetfeldmesseinheit (16) zum Messen einer Magnetfeldänderung in dem ferromagnetischen Körper (9) umfasst, wobei die Magnetfelderzeugungseinheit (14) eine Erregerspule (18) und ein weichmagnetisches Erreger-Flussverstärkungselement (20, 42) aufweist und die Magnetfeldmesseinheit (16) eine Messspule (22, 22a-22d) und ein weichmagnetischen Mess-Flussverstärkungselement (24, 42) aufweist, umfassend:
a) die Schritte:
Vorsehen mehrerer Leiterplatten (36),
Strukturieren einer Leiterschicht (38) der jeweiligen Leiterplatte (36), um Planarspulen mit Windungen (40) der Erregerspule (18) und der Messspule (22, 22a-22d) auszubilden, und
Aufstapeln der Leiterplatten (36) zu einem Paket, um Spulenpakete zum Bilden einer ersten Messspule (22a), einer zweiten Messspule (22b) und der Erregerspule (18) gleichzeitig aufzubauen,
oder
b) den Schritt: integriertes Ausbilden von Windungen (40) der Erregerspule (18) und der Messspule (22, 22a-22d) durch mikromechanische Fertigung oder additive Fertigungsverfahren, wobei in einer gemeinsamen Ebene Leiterschichten (38) derart strukturiert aufgebracht werden, dass mehrere Planarspulen nebeneinander zum Bilden einer ersten Messspule (22a) und einer zweiten Messspule (22b) und der Erregerspule (18) gebildet werden und dass mehrere solche mit Planarspulen versehene Leiterschichten (38) mit Isolationsschichten dazwischen zu Spulenpaketen aufgebaut werden.

10. Verfahren nach Anspruch 9,
**dadurch gekennzeichnet,**
**dass** Alternative a) enthält: Einbetten eines weichmagnetischen Materials in die Leiterplatten (36) zum Bilden der Flussverstärkungselemente (20, 24) oder
**dass** Alternative b) enthält: integriertes Ausbilden von Windungen (40) der Erregerspule (18) und der Messspulen (22, 22a-22d) und der weichmagnetischen Kerne durch mikromechanische Fertigung oder additive Fertigungsverfahren.

11. Verfahren nach Anspruch 9 oder 10,
**dadurch gekennzeichnet,**
**dass** Alternative a) enthält: Aufkleben wenigstens einer ferritischen Folie (42) auf wenigstens eine der Leiterplatten (36) zum Bilden der Flussverstärkungselemente (20, 24).

12. Verfahren nach Anspruch 11,
**gekennzeichnet durch**:
12.1 Bereitstellen der wenigstens einen ferritischen Folie mit einer Dicke von
0,1 mm bis 3 mm und/oder
12.2 Bereitstellen einer Folie (42) aus oder mit einem Eisenoxyd.

13. Verfahren nach einem der Ansprüche 9 bis 12,
**gekennzeichnet durch**
Vorsehen eines Chips mit einer signalverarbeitenden Elektronik (4) und elektrisches Verbinden von Anschlüssen des Chips mit den Spulen (18, 22), um so ein Sensorpackage (12) zu bilden.

14. Verfahren nach einem der Ansprüche 9 bis 13,
**gekennzeichnet durch** Umspritzen (5) zumindest des Pakets Leiterplatten (36) oder eines **durch** mikromechanische Fertigung gebildeten MEMS-Bausteins (28) mit den Spulen (18, 22) und den Flussverstärkungselementen (20, 24) **durch** ein Polymermaterial.

## Claims

1. Sensor head (10) for a force or torque sensor for measuring a force or torque in a ferromagnetic body (9), comprising:
a magnetic field generating unit (14) for generating a magnetic field in the ferromagnetic body (9), and a magnetic field measuring unit (16) for measuring a magnetic field change in the ferromagnetic body (9),
wherein the magnetic field generating unit (14) comprises an excitation coil (18) and a soft-magnetic excitation flux amplifying element (20),
wherein the magnetic field measuring unit (16) comprises a plurality of measuring coils (22) with a soft-magnetic measuring flux amplifying element (24),
wherein at least the excitation coil (18) and the measurement coils (22, 22a-22d) are integrated on a common circuit board element (26) or MEMS device (28),
wherein the excitation coil (18) and the measurement coils (22, 22a-22d) are composed of planar coils formed in a conductor layer (38) of the circuit board element (28),
wherein the conductor layer (38) includes a planar coil for forming a part of a first measurement coil (22a) and a planar coil for forming a part of a second measurement coil (22b) and a planar coil for forming a part of an excitation coil (18) arranged in a plane, and a plurality of such conductor layers including a plurality of planar coils are arranged with insulating interlayers to form coil packs forming the first measurement coil (22, 22a) and the second measurement coil (22, 22b) and the excitation coil (18).

2. Sensor head according to claim 1,
**characterized in that**
the circuit board element (26) comprises a plurality of circuit boards (36) each comprising a conductor layer (38) and a support layer formed of an insulator and stacked into a package.

3. Sensor head according to any one of the preceding claims,
**characterized in that**
the soft-magnetic excitation flux amplifying element is a soft-magnetic excitation core (20) around which the excitation coil (18) is arranged, and **in that** the measurement coils (22) are provided with a soft-magnetic measuring core (24) as measuring flux amplifying element.

4. Sensor head (10) according to any one of the preceding claims,
**characterized in that**
at least one ferritic foil (42) is provided, which forms at least a part of one of the soft-magnetic flux amplifying elements.

5. Sensor head (10) according to claim 2 and according to claim 4,
**characterized in that**
the ferritic foil (42) is bonded to the circuit board element (26).

6. Sensor head (10) according to any one of the preceding claims,
**characterized by** a first circuit board element (26) on which at least the excitation coil (18) and a plurality of measurement coils (22, 22a-22d) are integrally provided so as to form a plurality of magnetic poles (30, 30a-30e), and by a second circuit board element (26) in which at least one soft-magnetic material for connecting and/or forming soft-magnetic cores of the magnetic poles (30, 30a-30e) is embedded or integrated, the first and second circuit board elements (26) being connected to each other; or **characterized by** a first MEMS device (28) on which at least said excitation coil (18) and a plurality of measurement coils (22, 22a-22d) are integrally provided so as to form a plurality of magnetic poles (30, 30a-30e), and by a second MEMS device (28) in which at least one soft-magnetic material for connecting and/or forming soft-magnetic cores of the magnetic poles (30, 30a-30e) is embedded or integrated, wherein the first and second MEMS devices (26) are connected to each other.

7. Sensor head (10) according to any one of the preceding claims,
**characterized by** an integrated circuit disposed on or bonded or soldered to or formed as an integral part of the circuit board element (26) or the MEMS device (28).

8. Sensor head (10) according to any one of the preceding claims,
**characterized in**
**that** the PCB element (26) or the MEMS device (28) is overmolded with the integrated coils (6) and the soft-magnetic flux enhancement elements (20, 24, 34, 42) by a polymer.

9. Method of manufacturing a sensor head (10) for a magnetoelastic force or torque sensor for measuring a force or torque in a ferromagnetic body (9), which sensor head (10) comprises a magnetic field generating unit (14) for generating a magnetic field in the ferromagnetic body (9) and a magnetic field measuring unit (16) for measuring a magnetic field change in the ferromagnetic body (9), wherein the magnetic field generating unit (14) comprises an excitation coil (18) and a soft-magnetic excitation flux amplifying element (20, 42), and the magnetic field measuring unit (16) comprises a measurement coil (22, 22a-22d) and a soft-magnetic measuring flux amplifying element (24, 42), comprising:
(a) the steps of:
providing a plurality of circuit boards (36),
patterning a conductor layer (38) of the respective circuit board (36) to form planar coils with windings (40) of the excitation coil (18) and the measurement coil (22, 22a-22d), and
stacking the circuit boards (36) into a package to form coil packages for forming a first measurement coil (22a), a second measurement coil (22b) and the excitation coil (18) simultaneously,
or
b) the step of:
integrally forming windings (40) of the excitation coil (18) and the measurement coil (22, 22a-22d) by micromechanical manufacturing or additive manufacturing processes, wherein conductor layers (38) are applied in a patterned manner in a common plane in such a way that a plurality of planar coils are formed side by side for forming a first measurement coil (22a) and a second measurement coil (22b) and the excitation coil (18), and that a plurality of such conductor layers (38) provided with planar coils are built up with insulation layers therebetween to form coil packs.

10. Method according to claim 9,
**characterized in**
**that** alternative a) comprises: embedding a soft-magnetic material into the circuit boards (36) to form the flux amplifying elements (20, 24) or that alternative b) includes: integrally forming windings (40) of the excitation coil (18) and the measurement coils (22, 22a-22d) and the soft-magnetic cores by micromechanical fabrication or additive manufacturing processes.

11. Method according to claim 9 or 10,
**characterized in**
**that** alternative a) comprises: bonding at least one ferritic foil (42) to at least one of the circuit boards (36) to form the flux amplification elements (20, 24).

12. Method according to claim 11,
**characterized by**:
12.1 providing the at least one ferritic foil having a thickness of 0.1 mm to 3 mm, and/or
12.2 providing a foil (42) of or comprising an iron oxide.

13. Method according to any one of claims 9 to 12,
**characterized by**
providing a chip with signal processing electronics (4) and electrically connecting terminals of the chip to the coils (18, 22) so as to form a sensor package.

14. Method according to any one of claims 9 to 13,
**characterized by** overmolding (5) at least the package of circuit boards (36) or a MEMS device (28) formed by micromechanical fabrication with the coils (18, 22) and the flux amplifying elements (20, 24) using a polymer material.

## Revendications

1. Tête de capteur (10) pour un capteur de force ou de couple magnétoélastique pour mesurer une force ou un couple dans un corps ferromagnétique (9), comprenant:
une unité de génération de champ magnétique (14) pour générer un champ magnétique dans le corps ferromagnétique (9), et une unité de mesure de champ magnétique (16) pour mesurer une variation de champ magnétique dans le corps ferromagnétique (9),
dans laquelle l'unité de génération de champ magnétique (14) comprend une bobine d'excitation (18) et un élément d'amplification de flux d'excitation magnétique doux (20),
dans laquelle l'unité de mesure du champ magnétique (16) comprend une pluralité de bobines de mesure (22) avec un élément d'amplification de flux de mesure magnétique doux (24),
dans laquelle au moins la bobine d'excitation (18) et les bobines de mesure (22, 22a-22d) sont intégrées sur un élément de carte de circuit commun (26) ou un dispositif MEMS (28),
dans laquelle la bobine d'excitation (18) et les bobines de mesure (22, 22a-22d) sont composées de bobines planes formées dans une couche conductrice (38) de l'élément de carte de circuit (26) ou du dispositif MEMS (28),
dans laquelle, dans la couche conductrice (38), sont disposées dans un plan une bobine plane pour former une partie d'une première bobine de mesure (22a) et une bobine plane pour former une partie d'une deuxième bobine de mesure (22b) et une bobine plane pour former une partie d'une bobine d'excitation (18) et une pluralité de telles couches conductrices comprenant une pluralité de bobines planes avec des intercalaires isolants, pour former des paquets de bobines constituant la première bobine de mesure (22, 22a) et la seconde bobine de mesure (22, 22b) et la bobine d'excitation (18).

2. Tête de capteur selon la revendication 1,
**caractérisée en ce que**
l'élément de carte de circuit (26) comprend une pluralité de cartes de circuit (36) comprenant chacune une couche conductrice (38) et une couche de support formée d'un isolant et empilée pour former un paquet.

3. Tête de capteur selon l'une quelconque des revendications précédentes,
**caractérisée en ce que**
l'élément d'amplification de flux d'excitation magnétique doux est un noyau d'excitation magnétique doux (20) autour duquel est disposée la bobine d'excitation (18), et **en ce que**
les bobines de mesure (22) sont pourvues d'un noyau de mesure magnétique doux (24) comme élément d'amplification de flux de mesure.

4. Tête de capteur (10) selon l'une des revendications précédentes,
**caractérisée en ce que**
au moins une feuille ferritique (42) est prévue pour former au moins une partie de l'un des éléments de renforcement de flux magnétique doux.

5. Tête de capteur (10) selon la revendication 2 et selon la revendication 4,
**caractérisée en ce que**
la feuille ferritique (42) est liée à l'élément de carte de circuit (26).

6. Tête de capteur (10) selon l'une quelconque des revendications précédentes,
**caractérisée par** un premier élément de carte de circuit (26) sur lequel au moins la bobine d'excitation (18) et une pluralité de bobines de mesure (22, 22a-22d) sont intégralement prévues de sorte qu'une pluralité de pôles magnétiques (30, 30a-30e) sont formés, et par un second élément de carte de circuit (26) dans lequel au moins un matériau magnétique doux pour connecter et/ou former des noyaux magnétiques doux des pôles magnétiques (30, 30a-30e) est incorporé ou intégré, les premier et second éléments de carte de circuit (26) étant interconnectés;
ou **caractérisée par** un premier dispositif MEMS (28) sur lequel au moins la bobine d'excitation (18) et une pluralité de bobines de mesure (22, 22a-22d) sont intégralement prévues de manière à former une pluralité de pôles magnétiques (30, 30a-30e), et par un second dispositif MEMS (28) dans lequel au moins un matériau magnétique doux pour connecter et/ou former des noyaux magnétiques doux desdits pôles magnétiques (30, 30a-30e) est incorporé ou intégré, lesdits premier et second dispositifs MEMS (26) étant connectés l'un à l'autre.

7. Tête de capteur (10) selon l'une quelconque des revendications précédentes,
**caractérisée par** un circuit intégré disposé sur ou lié ou soudé à ou formé en tant que partie intégrante de l'élément de carte de circuit (26) ou du dispositif MEMS (28).

8. Tête de capteur (10) selon l'une quelconque des revendications précédentes,
**caractérisée en ce que**
l'élément de carte de circuit (26) ou le dispositif MEMS (28) est surmoulé avec les bobines intégrées (6) et les éléments de renforcement de flux magnétique doux (20, 24, 34, 42) par un polymère.

9. Procédé de fabrication d'une tête de capteur (10) pour un capteur de force ou de couple magnétoélastique pour mesurer une force ou un couple dans un corps ferromagnétique (9), laquelle tête de capteur (10) comprend une unité de génération de champ magnétique (14) pour générer un champ magnétique dans le corps ferromagnétique (9) et une unité de mesure de champ magnétique (16) pour mesurer une variation de champ magnétique dans le corps ferromagnétique (9), ladite unité de génération de champ magnétique (14) ayant une bobine d'excitation (18) et un élément d'amplification de flux d'excitation magnétique doux (20, 42), et ladite unité de mesure de champ magnétique (16) ayant une bobine de mesure (22, 22a-22d) et un élément d'amplification de flux de mesure magnétique doux (24, 42), comprenant:
(a) les étapes de:
fournir une pluralité de cartes de circuits imprimés (36),
formation de motifs sur une couche conductrice (38) de la carte de circuit respective (36) pour former des bobines planes avec des enroulements (40) de la bobine d'excitation (18) et de la bobine de mesure (22, 22a-22d), et
empiler les cartes de circuits (36) dans un paquet pour former des paquets de bobines pour former une première bobine de mesure (22a), une deuxième bobine de détection (22b) et la bobine d'excitation (18) simultanément,
ou
b) l'étape de:
former intégralement des enroulements (40) de la bobine d'excitation (18) et de la bobine de mesure (22, 22a-22d) par des procédés de fabrication micromécanique ou de fabrication additive, dans lesquels des couches conductrices (38) sont appliquées dans un plan commun d'une manière structurée de telle manière qu'une pluralité de bobines planes sont formées côte à côte pour former une première bobine de mesure (22a) et une seconde bobine de mesure (22b) et la bobine d'excitation (18), et qu'une pluralité de telles couches conductrices (38) munies de bobines planes sont construites avec des couches d'isolation entre elles pour former des paquets de bobines.

10. Procédé selon la revendication 9,
**caractérisé en ce que**
l'alternative a) comprend: l'incorporation d'un matériau magnétique doux dans les cartes de circuits (36) pour former les éléments d'amplification de flux (20, 24) ou l'alternative b) comprend: la formation intégrée des enroulements (40) de la bobine d'excitation (18) et des bobines de mesure (22, 22a-22d) et des noyaux magnétiques doux par des procédés de fabrication micromécanique ou de fabrication additive.

11. Procédé selon la revendication 9 ou 10,
**caractérisé en ce que**
l'alternative a) comprend: faire adhérer au moins une feuille ferritique (42) à au moins une des cartes de circuits imprimés (36) pour former les éléments d'amplification de flux (20, 24).

12. Procédé selon la revendication 11,
**caractérisé par**:
12.1 fournir ladite au moins une feuille ferritique ayant une épaisseur de 0,1 mm à 3 mm, et/ou
12.2 fournir une feuille (42) de ou comprenant un oxyde de fer.

13. Procédé selon l'une quelconque des revendications 9 à 12,
**caractérisé par**
fournir une puce avec une électronique de traitement du signal (4) et connecter électriquement des bornes de la puce aux bobines (18, 22) de manière à former un ensemble de capteurs (12).

14. Procédé selon l'une quelconque des revendications 9 à 13,
**caractérisé par** le surmoulage (5) d'au moins le paquet de cartes de circuits imprimés (36) ou d'un dispositif MEMS (28) formé par fabrication micromécanique avec les bobines (18, 22) et les éléments d'amplification de flux (20, 24) par un matériau polymère.
